# FASCICULE DE BREVET EUROPEEN

(11) **EP 2 609 604 B1**
(45) Date de publication et mention de la délivrance du brevet: **25.04.2018**
(21) Numéro de dépôt: 11773019.2
(22) Date de dépôt: 23.08.2011
(51) Int. Cl.: H01G 4/228, H01G 2/06, H05K 3/34, H01G 4/12

(54) **CIRCUIT IMPRIME COMPORTANT AU MOINS UN COMPOSANT CERAMIQUE**
LEITERPLATTE MIT MINDESTENS EINER KERAMIKKOMPONENTE
PRINTED CIRCUIT COMPRISING AT LEAST ONE CERAMIC COMPONENT

(30) Priorité: 25.08.2010 FR 1056769
(43) Date de publication de la demande: 03.07.2013
(73) Titulaire: Safran Electrical & Power, 31702 Blagnac Cedex (FR)
(72) Inventeur: LHOMMEAU, Tony, F-77550 Moissy-Cramayel Cedex (FR)
(74) Mandataire: Lebkiri, Alexandre
(86) Numéro de dépôt international: PCT/FR2011/051950
(87) Numéro de publication internationale: WO 2012/025693

(56) Documents cités:
- JP-A- 10 275 740
- JP-A- 61 149 449
- US-A- 6 081 416
- US-A1- 2002 130 161
- US-A1- 2009 147 440
- US-B1- 6 365 973
- DATABASE WPI Week 198847 Thomson Scientific, London, GB; AN 1988-333519 XP002617348, -& JP 63 245811 A (SUMITOMO LIGHT METAL IND CO) 12 octobre 1988 (1988-10-12)

## Description

### DOMAINE TECHNIQUE

La présente invention concerne un circuit imprimé comportant au moins un composant électronique ou électrique céramique. Plus précisément, la présente invention concerne une solution d'assemblage pour composants électriques ou électroniques céramiques sur un circuit imprimé, en particulier lorsque ce circuit imprimé se trouve dans un environnement sévère embarqué, par exemple dans un moteur de turboréacteur.

### ETAT DE LA TECHNIQUE ANTERIEUR

L'utilisation de condensateurs céramiques sur des cartes ou assemblages électroniques pose des problèmes de fiabilité, en partie dus à la fragilité du matériau constitutif de ces condensateurs céramiques. En effet, la céramique ne supporte pas les contraintes mécaniques supérieures à sa limite élastique et par conséquent, elle a tendance à se fissurer. Ces fissures limitent la capacité des condensateurs et peuvent même provoquer un claquage diélectrique. Ce problème est particulièrement important dans les condensateurs de taille supérieure à 1 cm.

De même, les résistances céramiques présentent des problèmes de fiabilité lorsqu'elles sont fixées sur des circuits imprimés. Ce problème est couramment observé lorsque le support et le composant reporté sur ce support présentent des coefficients d'expansion thermique différents l'un de l'autre.

Les solutions actuelles pour remédier à ce problème consistent soit à limiter la taille des composants, ce qui limitent également leur capacité, soit à utiliser des connecteurs intermédiaires pour fixer les composants céramiques à leur support. Ces connecteurs intermédiaires doivent présenter un coefficient d'expansion thermique proche de celui de la céramique, pour éviter les fissures du composant céramique. Ainsi, actuellement, les connecteurs intermédiaires sont réalisés dans un alliage type FeNiCo qui présente un coefficient d'expansion thermique environ égal à 6 ppm/K.

Cependant, le demandeur a constaté que l'utilisation de tels connecteurs intermédiaires conduit à un échauffement des composants céramiques, ce qui peut conduire à une diminution de leur capacité. En particulier, lorsque plusieurs composants céramiques sont reliés en parallèle via deux connecteurs en FeNiCo, le demandeur a constaté que le composant monté en parallèle le plus éloigné du support s'échauffait de manière plus importante que le composant monté en parallèle le plus proche du support. Cette distribution de température limite donc le nombre de composants que l'on peut monter en parallèle. En outre, cette distribution de température peut entraîner une diminution de la capacité du condensateur situé le plus loin du support et en particulier lorsqu'on atteint une température supérieure à 125°C. Le demandeur a également constaté que l'utilisation des connecteurs de l'art antérieur pouvait augmenter les contraintes thermo-mécaniques dans la céramique du composant. US6081416 divulgue un composant céramique apte à être monté sur un circuit imprimé, le composant céramique comportant deux connecteurs métalliques.

### EXPOSE DE L'INVENTION

L'invention vise à remédier, au moins partiellement, aux inconvénients de l'état de la technique en proposant un circuit imprimé sur lequel des composants céramiques de toutes tailles peuvent être fixés.

Un autre objet de l'invention est de proposer un circuit imprimé sur lequel des composants céramiques peuvent être fixés, avec un risque réduit de fissuration de ces composants céramiques.

Un autre objet de l'invention est de proposer des moyens de fixation d'un composant céramique sur un circuit imprimé qui permettent de limiter l'échauffement du composant.

Un autre objet de l'invention est de proposer des moyens de fixation de plusieurs composants céramiques en parallèle sur un circuit imprimé qui permettent de limiter l'échauffement du composant céramique le plus éloigné du support.

Un autre objet de l'invention est de proposer un circuit imprimé sur lequel les composants céramiques sont plus solidement fixés.

Un autre objet de l'invention est de proposer un circuit imprimé dans lequel les contraintes mécaniques sont diminuées.

Pour ce faire, est proposé, selon un premier aspect de l'invention, un circuit imprimé selon la revendication 1 comportant un support sur lequel est monté au moins un composant céramique, le composant céramique étant fixé au support par l'intermédiaire de deux connecteurs, chaque connecteur étant constitué d'un matériau composite à matrice métallique.

Le choix d'un connecteur en matériau composite à matrice métallique est particulièrement avantageux car il présente un coefficient d'expansion thermique proche de celui de la céramique et par conséquent, il permet de limiter les risques de fissures du composant céramique.

En outre, un connecteur en matériau composite à matrice métallique présente une conductivité thermique élevée, et il permet donc une bonne évacuation de la chaleur issue du ou des composants céramiques, y compris lorsque ces composants céramiques sont reliés en parallèle. En effet, les connecteurs en matériau composite à matrice métallique ont des conductivités thermiques supérieures à 300 W/mK, ce qui permet de réduire considérablement l'auto-échauffement du composant céramique tout en préservant son intégrité mécanique puisqu'on évite sa fissuration. En outre, les connecteurs en matériau composite à matrice métallique permettent d'avoir une température homogène dans l'ensemble du circuit imprimé malgré des variations sensibles de géométrie entre le circuit imprimé et le premier composant.Par ailleurs, l'invention permet de relier un grand nombre de composants céramiques en parallèle entre les deux connecteurs, puisque la chaleur du composant céramique situé le plus loin du support peut être évacuée par l'intermédiaire des connecteurs en matériau composite à matrice céramique. Le matériau composite à matrice métallique est pris dans le groupe suivant : Cu-C, Cu-Diamant, Al-C, Al-SiC, Al-diamant. On entend par la dénomination « Cu-C » un matériau composite présentant une matrice en cuivre et un renfort en carbone. De même, pour les autres matériaux composites cités : l'élément chimique cité en premier lieu désigne l'élément qui constitue la matrice, et l'élément chimique cité en deuxième désigne l'élément qui constitue le renfort.

Le choix de ces matériaux pour réaliser les connecteurs permet d'avoir des connecteurs qui présentent un coefficient d'expansion thermique compris entre 6 et 16 ppm/K et une conductivité thermique supérieure à 150 W/mK, ce qui permet à la fois d'éviter les fissures dans les composants céramiques, et d'évacuer la chaleur produite par ces composants céramiques.

Selon un mode de réalisation préférentiel, chaque connecteur comporte une base située entre le composant céramique et le support, la base étant incisée par une entaille. Cette entaille dans la base de chaque connecteur permet de limiter les contraintes mécaniques et thermiques dans le support. En effet, cette entaille permet de reporter les contraintes, qui se trouvent normalement dans le support, dans la base, au niveau de l'entaille. Or comme les connecteurs sont plus résistants que le support, cela permet d'augmenter la durée de vie du circuit imprimé.

Ces entailles ne sont possibles que parce que les connecteurs présentent une bonne conductivité thermique. En effet, si tel n'était pas le cas, le fait de réduire la section de la base de chaque conducteur empêcherait la chaleur d'être évacuée des composants céramiques et conduirait donc à un échauffement des composants céramiques.

Avantageusement, le support s'étend parallèlement à un plan XZ, le composant céramique s'étendant parallèlement à l'axe X, les connecteurs s'étendant parallèlement à un axe Y perpendiculaire au plan XZ.

Avantageusement, l'entaille définit trois zones dans la base de chaque connecteur :
- Une partie de section réduite, située au niveau de l'entaille ;
- Un pied et une connexion, situés de part et d'autre de la partie de section réduite, et qui présentent donc une section supérieure à celle de la partie de section réduite.

Lorsqu'une entaille est réalisée dans le connecteur, elle s'étend de préférence suivant l'axe X.

Avantageusement, le pied est en outre découpé en plusieurs pattes. Avantageusement, ce découpage a lieu suivant une direction perpendiculaire à la direction de l'entaille. Le pied est donc de préférence découpé selon l'axe Z.

Ce découpage du pied, par exemple en créneau, permet de diminuer les contraintes thermo-mécaniques dans le pied, suivant l'axe de découpage, ce qui permet d'augmenter la durée de vie de l'assemblage.

Selon différents modes de réalisation :
- Le pied peut être dirigé vers le composant céramique, c'est-à-dire que le pied est formé par la partie de la base située entre l'entaille et le support, dans la continuité du connecteur ; ce mode de réalisation permet un gain de place ; ou
- le pied peut être déplié vers l'extérieur du composant céramique, c'est-à-dire que le pied est tourné de façon à se retrouver à 180° de la position précédente. Dans ce cas, le pied n'est pas plus sous le composant céramique ; ce mode de réalisation permet une meilleure fixation des connecteurs au support.

L'invention concerne tout particulièrement le cas où le composant céramique est un condensateur céramique.

Avantageusement, au moins deux composants céramiques sont reliés en parallèle par l'intermédiaire des deux connecteurs. En effet, l'invention permet de relier plusieurs composants céramiques en parallèle, sans que le composant céramique situé le plus loin du support n'ai une température d'échauffement supérieure au composant céramique situé le plus près du support.

Avantageusement, la base présente une hauteur, suivant l'axe Y, supérieure à 4 mm.

Avantageusement, l'entaille se trouve à une distance, suivant l'axe Y, du composant le plus proche du support comprise entre 2 mm et 6 mm, ce qui permet d'éviter les contraintes thermo-mécaniques après fixation du connecteur au support. Avantageusement, le connecteur présente une épaisseur, suivant l'axe X, d'environ 2 mm.

Avantageusement, la partie de section réduite présente une épaisseur, suivant l'axe X, comprise entre 0.25 et 1 mm, de façon à limiter les contraintes thermomécaniques et à augmenter la durée de vie du composant.

L'invention concerne également l'utilisation d'un matériau composite à matrice métallique selon la revendication 8 pour relier un composant céramique à un support dans un circuit imprimé. c'est à dire Cu-C, Cu-Diamant, Al-C, Al-SiC, Al-diamant. L'invention concerne également l'utilisation d'un matériau composite à matrice métallique selon la revendication 9 pour relier plusieurs composants céramiques en parallèle à un support dans un circuit imprimé.

### BREVES DESCRIPTION DES FIGURES

D'autres caractéristiques et avantages de l'invention ressortiront à la lecture de la description détaillée qui suit, en référence aux figures annexées, qui illustrent :
- La figure 1, une vue en perspective d'un circuit imprimé selon un mode de réalisation de l'invention ;
- La figure 2, une vue de face du circuit imprimé de la figure 1 ;
- La figure 3, une vue de face d'un circuit imprimé selon un autre mode de réalisation de l'invention ;
- La figure 4, une vue de côté du circuit imprimé de la figure 3 ;
- La figure 5, une vue de dessus du circuit imprimé de la figure 3.

Pour plus de clarté, les éléments identiques ou similaires sont repérés par des signes de références identiques sur l'ensemble des figures.

### DESCRIPTION DETAILLEE D'AU MOINS UN MODE DE REALISATION

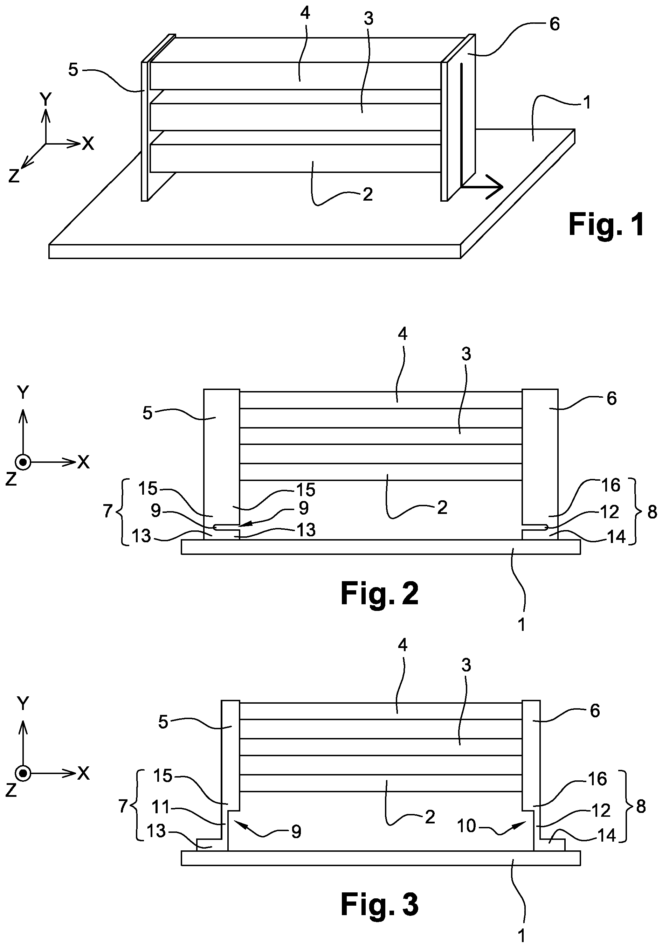

Les figures 1 et 2 représentent un circuit imprimé selon un premier mode de réalisation de l'invention. Ce circuit imprimé comporte un support 1. Ce support 1 est de préférence constitué d'un assemblage d'une ou plusieurs fines couches de cuivre séparées par un matériau isolant. Ce matériau isolant peut par exemple être du polyamide, de la résine époxy ou des fibres de verre. Le support 1 présente généralement un coefficient d'expansion thermique compris entre 4 et 25 ppm/K.

Le support 1 s'étend parallèlement à un plan XZ.

Le circuit imprimé comporte également trois composants céramiques 2, 3, 4 reliés au support 1 en parallèle. Dans cet exemple, le nombre de composants céramiques reliés en parallèle est égal à 3, mais on pourrait également choisir un autre nombre de composants céramiques sans sortir du cadre de l'invention. De manière générale, on pourrait relier un nombre n de composants céramiques en parallèle, n étant supérieur où égal à 1.

Les composants céramiques 2, 3, 4 sont dans ce mode de réalisation des condensateurs céramiques, mais on pourrait également réaliser l'invention avec d'autres types de composants céramiques, par exemple avec des résistances céramiques.

Chaque composant céramique s'étend parallèlement à l'axe X.

Les trois composants céramiques 2, 3, 4 sont reliés au support 1 par l'intermédiaire de deux connecteurs 5 et 6 qui s'étendent chacun parallèlement à l'axe Y.

L'invention est particulièrement remarquable en ce que chaque connecteur 5, 6 est constitué d'un matériau composite à matrice métallique. Ce matériau composite à matrice métallique est un des matériaux suivants : Cu-C, Cu-Diamant, Al-C, Al-SiC, Al-diamant.

Ainsi, chaque connecteur 5, 6 présente un coefficient d'expansion thermique suivant les axes Y et Z qui est proche du coefficient d'expansion thermique de la céramique. En effet, chaque connecteur 5, 6 présente ainsi un coefficient d'expansion thermique suivant les axes Y et Z qui est compris entre 8 et 16 ppm/K, ce qui permet de limiter les contraintes thermo-mécaniques lors de l'assemblage des composants céramiques 2, 3, 4 sur le support 1. Ainsi, la présence des connecteurs 5, 6 permet de limiter le risque de fissure dans les composants céramique dû à la différence de coefficient d'expansion thermique entre le support 1 et les composants céramiques 2, 3 et 4.

En outre, chaque connecteur 5, 6 présente ainsi une conductivité thermique supérieure à 150 W/mK suivant les axes Y et Z, ce qui permet de favoriser la dissipation du flux thermique. Ainsi, la chaleur produite par chacun des composants céramiques 2, 3 et 4 peut être évacuée par l'intermédiaire des connecteurs 5 et 6, ce qui évite la surchauffe des composants céramiques 2 à 4. Ainsi, l'invention permet de relier en parallèle un grand nombre de composants céramiques, puisque, même lorsqu'un grand nombre de composants céramiques sont empilés, la chaleur qu'ils produisent peut être évacuée.

Chaque connecteur 5, 6 peut être fixé sur le support 1 par brasage, soudo-brasage, soudage, collage ou tout autre moyen d'assemblage habituellement utilisé pour fixer un composant sur un circuit imprimé.

De même, chaque composant céramique 2, 3, 4 peut être rendu solidaire de chacun des connecteurs 5, 6 par brasage, soudo-brasage, soudage, collage ou tout autre moyen d'assemblage habituellement utilisé pour fixer un composant sur un connecteur.

Chaque connecteur 5, 6 comporte une base 7, 8. La base 7, 8 est la partie du connecteur 5, 6 qui est située entre le support 1 et le composant céramique 2 le plus proche du support 1. La base 7, 8 présente de préférence une hauteur, suivant l'axe Y, au moins égale à 4 mm de façon à permettre la circulation de l'air entre le composant céramique et le support et à diminuer les contraintes thermo-mécaniques entre le support et le composant céramique 2 le plus proche du support.

Chaque base 7, 8 est de préférence incisée, suivant l'axe X, par une entaille 9, 10. Le fond de chaque entaille 9, 10 est de préférence arrondi pour éviter que le connecteur ne casse au niveau de l'entaille 9, 10. Chaque entaille 9, 10 partage la base 7, 8 à laquelle elle appartient en trois zones :
- Une partie de section réduite 11, 12 ;
- Un pied 13, 14, situé à proximité du support ;
- Une connexion 15, 16, située à proximité du composant céramique.

Chaque connecteur 5, 6 présente de préférence une épaisseur, suivant l'axe X, sensiblement égale à 2 mm.

Dans ce cas, les entailles 9 et 10 sont de préférence effectuées de façon à ce que chaque partie de section réduite 11, 12 présente une épaisseur, suivant l'axe X, comprise entre 0,25 et 1 mm. La présence de cette entaille 9, 10 permet de reporter les contraintes thermo-mécaniques, qui sont normalement présentes dans le support, dans le pied 13, 14 du connecteur 5, 6. Or, comme les connecteurs 5, 6 sont plus résistants mécaniquement que le support, ce report des contraintes thermo-mécaniques permet d'augmenter la durée de vie du circuit imprimé.

En outre, l'entaille 9, 10 est de préférence réalisée à une distance, suivant l'axe Y, du composant céramique 2 le plus proche de support 1, qui est comprise entre 2 et 6 mm afin de limiter les contraintes thermo-mécaniques après fixation du composant céramique 2 sur le connecteur 5, 6.

En outre, les composants céramiques 2, 3 et 4 sont de préférence suffisamment éloignés les uns des autres pour permettre à l'air de circuler entre eux. Ainsi, les composants céramiques 2, 3, 4 sont de préférence éloignés d'une distance, suivant l'axe Y, comprise entre 0,5 et 1 mm.

Les figures 3 à 5 représentent un autre mode de réalisation dans lequel la base 7, 8 de chaque connecteur 5, 6 présente une autre forme que dans le mode de réalisation des figures 1 et 2. Dans ce mode de réalisation, le pied 13, 14 de chaque base 7, 8 n'est pas dans la continuité de chaque connecteur 5, 6, mais il est retourné en direction de l'extérieur des composants céramiques 2, 3, 4. Plus précisément, dans le mode de réalisation des figures 1 et 2, le pied 13 est dans la continuité du connecteur 5 et il est dirigé suivant l'axe +X. Au contraire, dans ce mode de réalisation, le pied 13 est plié à 180° par rapport au pied des figures 1 et 2, de sorte que le pied 13 est dirigé suivant l'axe -X. De même pour le pied 14 qui dans le mode de réalisation des figures 1 et 2 est dirigé suivant l'axe -X, tandis que dans ce mode de réalisation, le pied 14 est plié à 180° par rapport au mode de réalisation des figures 1 et 2 de façon à être dirigé selon l'axe +X.

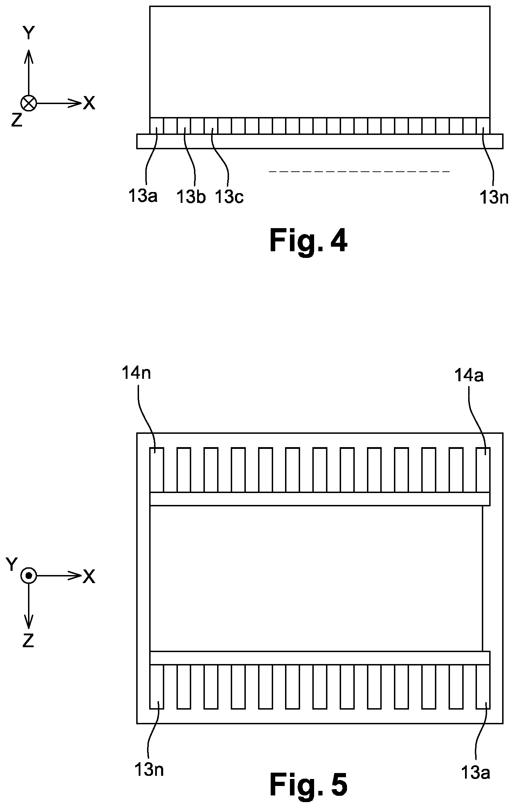

En outre, comme on peut le voir plus précisément sur les figures 4 et 5, chaque pied 13 et 14 est découpé suivant l'axe Z en plusieurs pattes 13 à 13n, respectivement 14a à 14n. Les pieds 13 et 14 sont de préférence découpés en créneau. Ce découpage des pieds permet de diminuer les contraintes thermo-mécaniques suivant l'axe Z, ce qui permet d'augmenter la durée de vie de l'assemblage entre les connecteurs 5, 6 et le support 1.

On pourrait également envisager de découper les pieds 13 et 14 du circuit imprimé des figures 1 et 2 afin de diminuer les contraintes suivant l'axe Z dans ce mode de réalisation également.

Naturellement l'invention n'est pas limitée aux modes de réalisation décrits en référence aux figures et des variantes pourraient être envisagées sans sortir de l'objet des revendications. On pourrait par exemple relier un seul composant électronique sur le support. On pourrait également réaliser des entailles présentant d'autres géométries dans chaque base. En outre, le découpage des pieds suivants l'axe Z pourrait prendre d'autres formes.

## Revendications

1. Circuit imprimé comportant un support (1) sur lequel est monté au moins un composant céramique (2, 3, 4), le composant céramique (2, 3, 4) étant fixé au support (1) par l'intermédiaire de deux connecteurs (5, 6), **caractérisé en ce que** chaque connecteur (5, 6) est constitué d'un matériau composite à matrice métallique, le matériau composite à matrice métallique étant pris dans le groupe suivant : Cu-C, Cu-Diamant, Al-C, Al-SiC, Al-diamant.

2. Circuit imprimé selon la revendication précédente, **caractérisé en ce que** chaque connecteur (5, 6) comporte une base (7, 8) située entre le composant céramique (2) et le support (1), la base (7, 8) étant incisée par une entaille (9, 10).

3. Circuit imprimé selon la revendication précédente, **caractérisé en ce que** l'entaille (9, 10) définit trois zones dans la base (7, 8) de chaque connecteur (5, 6):
- Une partie de section réduite (11, 12), située au niveau de l'entaille (9, 10),
- Un pied (13, 14) et une connexion (15, 16), situés de part et d'autre de la partie de section réduite (11, 12).

4. Circuit selon la revendication précédente, **caractérisé en ce que** le pied (13, 14) est découpé en plusieurs pattes (13a...13n, 14a...14n).

5. Circuit selon l'une quelconque des revendications 3 ou 4, **caractérisé en ce que** le pied (13, 14) est en outre déplié vers l'extérieur du composant céramique (2, 3, 4).

6. Circuit selon l'une quelconque des revendications précédentes, **caractérisé en ce que** le composant céramique (2, 3, 4) est un condensateur céramique.

7. Circuit selon l'une quelconque des revendications précédentes, **caractérisé en ce que** au moins deux composants céramiques (2, 3, 4) sont reliés en parallèle par l'intermédiaire des deux connecteurs (5, 6).

8. Utilisation d'un matériau composite à matrice métallique pour relier un composant céramique (2, 3, 4) à un support (1) dans un circuit imprimé, le matériau composite à matrice métallique étant pris dans le groupe suivant : Cu-C, Cu-Diamant, Al-C, Al-SiC, Al-diamant.

9. Utilisation d'un matériau composite à matrice métallique selon la revendication 8, **caractérisé en ce que** le matériau composite à matrice est utilisé pour relier plusieurs composants céramiques (2, 3, 4) en parallèle à un support (1) dans un circuit imprimé, le matériau composite à matrice métallique étant pris dans le groupe suivant : Cu-C, Cu-Diamant, Al-C, Al-SiC, Al-diamant.

## Patentansprüche

1. Gedruckte Leiterplatte, umfassend einen Träger (1), auf dem wenigstens ein Keramikbauteil (2, 3, 4) angebracht ist, wobei der Keramikbauteil (2, 3, 4) am Träger (1) mittels zwei Konnektoren (5, 6) befestigt ist, **dadurch gekennzeichnet, dass** jeder Konnektor (5, 6) aus einem Verbundmaterial mit Metallmatrix gebildet ist, wobei das Verbundmaterial mit Metallmatrix aus der folgenden Gruppe genommen ist: Cu-C, Cu-Diamant, Al-C, Al-SiC, AI-Diamant.

2. Gedruckte Leiterplatte gemäß dem voranstehenden Anspruch, **dadurch gekennzeichnet, dass** jeder Konnektor (5, 6) eine Basis (7, 8) umfasst, die zwischen dem Keramikbauteil (2) und dem Träger (1) angeordnet ist, wobei die Basis (7, 8) durch eine Kerbe (9, 10) eingekerbt ist.

3. Gedruckte Leiterplatte gemäß dem voranstehenden Anspruch, **dadurch gekennzeichnet, dass** die Kerbe (9, 10) drei Bereiche in der Basis (7, 8) jedes Konnektors (5, 6) definiert:
- einen Teil mit reduziertem Abschnitt (11, 12), der an der Kerbe (9, 10) angeordnet ist,
- einen Fuß (13, 14) und einen Anschluss (15, 16), die auf jeder Seite des Teils mit reduziertem Abschnitt (11, 12) angeordnet sind.

4. Leiterplatte gemäß dem voranstehenden Anspruch, **dadurch gekennzeichnet, dass** der Fuß (13, 14) in mehrere Laschen (13a, ... 13n, 14a ... 14n) ausgeschnitten ist.

5. Leiterplatte gemäß irgendeinem der Ansprüche 3 oder 4, **dadurch gekennzeichnet, dass** der Fuß (13, 14) darüber hinaus zur Außenseite des Keramikbauteils (2, 3, 4) entfaltet ist.

6. Leiterplatte gemäß irgendeinem der voranstehenden Ansprüche, **dadurch gekennzeichnet, dass** das Keramikbauteil (2, 3, 4) ein Keramikkondensator ist.

7. Leiterplatte gemäß irgendeinem der voranstehenden Ansprüche, **dadurch gekennzeichnet, dass** wenigstens zwei Keramikbauteile (2, 3, 4) parallel zueinander mittels der zwei Konnektoren (5, 6) verbunden sind.

8. Verwendung eines Verbundmaterials mit Metallmatrix zum Verbinden eines Keramikbauteils (2, 3, 4) an einem Träger (2) in einer gedruckten Leiterplatte, wobei das Verbundmaterial mit Metallmatrix aus der folgenden Gruppe genommen ist: Cu-C, Cu-Diamant, Al-C, Al-SiC, Al-Diamant.

9. Verwendung eines Verbundmaterials mit Metallmatrix gemäß Anspruch 8, **dadurch gekennzeichnet, dass** das Verbundmaterial mit Matrix zum Verbinden von mehreren Keramikbauteilen (2, 3, 4) parallel zu einem Träger (1) in einer gedruckten Leiterplatte verwendet wird, wobei das Verbundmaterial mit Metallmatrix aus der folgenden Gruppe genommen ist: Cu-C, Cu-Diamant, Al-C, Al-SiC, Al-Diamant.

## Claims

1. A printed circuit comprising a support (1) on which is mounted at least one ceramic component (2, 3, 4), wherein the ceramic component (2, 3, 4) is attached to the support (1) by means of two connectors (5, 6), **characterized in that** each connector (5, 6) is made of a metal matrix composite material is selected from the following group: Cu-C, Cu-diamond, Al-C, Al-SiC, Al-diamond.

2. The printed circuit according to the preceding claim, **characterized in that** each connector (5, 6) comprises a base (7, 8) located between the ceramic component (2) and the support (1), wherein the base (7, 8) is cut via a notch (9, 10).

3. The printed circuit according to the preceding claim, **characterized in that** the notch (9, 10) defines three zones in the base (7, 8) of each connector (5, 6):
- a portion of reduced section (11, 12), located at the notch (9, 10),
- a foot (13, 14) and a connection (15, 16) located on both sides of the portion of reduced section (11, 12).

4. The circuit according to the preceding claim, **characterized in that** the foot (13, 14) is cut into several tabs (13a...13n, 14a...14n).

5. The circuit according to any one of claims 3 or 4, **characterized in that** the foot (13, 14) is further unfolded outwardly from the ceramic component (2, 3, 4).

6. The circuit according to any one of the preceding claims, **characterized in that** the ceramic component (2, 3, 4) is a ceramic capacitor.

7. The circuit according to any one of the preceding claims, **characterized in that** at least two ceramic components (2, 3, 4) are connected in parallel by means of the two connectors (5, 6).

8. A use of a metal matrix composite material for connecting a ceramic component (2, 3, 4) to a support (1) in a printed circuit, the metal matrix composite material being selected from the following group: Cu-C, Cu-diamond, Al-C, Al-SiC, Al-diamond.

9. A use of a metal matrix composite material according to claim 8, **characterized in that** the matrix composite material is used for connecting several ceramic components (2, 3, 4) in parallel to a support (1) in a printed circuit, the metal matrix composite material being selected from the following group: Cu-C, Cu-diamond, Al-C, Al-SiC, Al-diamond.
